# EUROPEAN PATENT APPLICATION

(11) **EP 1 603 166 A1**
(43) Date of publication of application: **07.12.2005**
(21) Application number: 05253435.1
(22) Date of filing: 03.06.2005
(51) Int. Cl.: H01L 27/146, H01L 31/0216, H01L 31/0232

(54) **Image pickup device and camera module**

(30) Priority: 04.06.2004 JP 2004167803
(71) Applicant: SHARP KABUSHIKI KAISHA, Osaka-shi, Osaka 545-8522 (JP)
(72) Inventor: Tanida, Yoshinori, Tenri-shi Nara 632-0004 (JP); Fukuda, Hiroaki, Nara-shi Nara 631-0003 (JP); Tojo, Yukio, Osaka-shi, Osaka 544-0032 (JP)
(74) Representative: Brown, Kenneth Richard

(57) **Abstract**

The surface of the image pickup device 21 is covered by a transparent conductive member 26 that is made of, for example, a transparent conductive past resin and that is electrically connected to a ground potential GND. By having this arrangement, it is possible to electromagnetically shield the image pickup device 30 itself. The transparent conductive member 26 has one or more openings in the parts that correspond to the conductive unit of the signal wiring portion (the electrodes 23; A to D, F, and G, and the wiring patterns 25 that are connected thereto), out of the electrodes 23 and the wiring patterns 25 provided on the front surface side of the image pickup device body unit 21.

## Description

### 1. FIELD OF THE INVENTION:

The present invention relates to image pickup devices such as CMOS image sensors and CCD image sensors used as image pickup units in video cameras, digital still cameras, mobile phones with a camera, portable information terminal devices with a camera and the like, as well as to camera modules including such image pickup devices.

### 2. DESCRIPTION OF THE RELATED ART:

The following describes a conventional camera module of this type, with reference to the drawings.

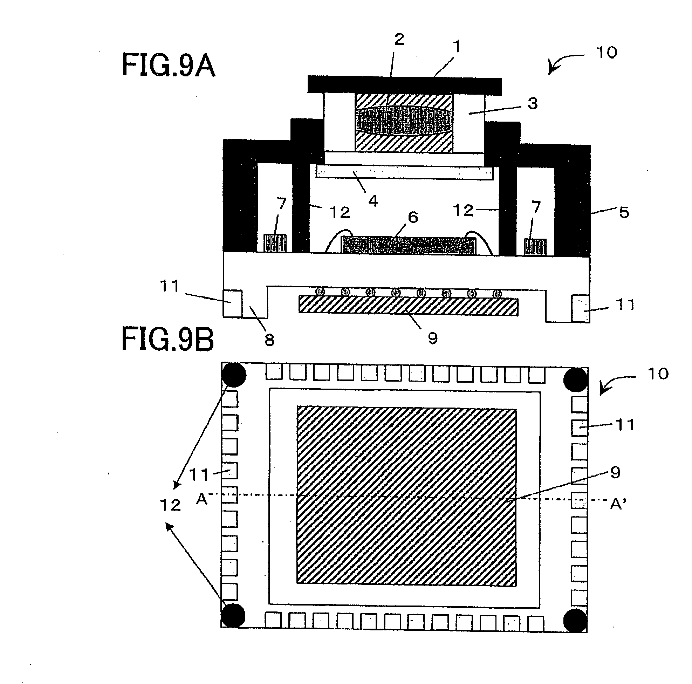

Figure 9A is a cross sectional view of the main parts to show an exemplary configuration of a conventional camera module. Figure 9B is a rear side view of the camera module shown in Figure 9A. Figure 9A is a cross sectional view at the line A-A' in Figure 9B.

As shown in Figure 9A and Figure 9B, a camera module 10 includes a lens cap 1, a lens 2, a lens barrel 3 that holds the lens 2, an IR (infrared ray) cut filter 4, a camera case 5 that holds these elements together, an image pickup device 6 on which light from an object is incident via the lens 2 and the IR cut filter 4, electric parts 7, a substrate 8 on which the image pickup device 6 and the electric parts 7 are mounted, and a DSP (Digital Signal Processor) 9 that processes signals from the image pickup device 6.

The lens 2 is a convex lens such as a spherical lens or a non-spherical lens and is assembled in the lens barrel 3 so as to be disposed on the light incident side of the image pickup device 6. With the lens 2, incident light from the outside (light from an object) forms an image on the image pickup device 6. The lens cap 1 which is removable when an image is to be taken is provided on the light incident side of the lens 2. It should be noted that the lens 2 may be configured as a plurality of lenses such as convex lenses; however, a single convex lens is illustrated in Figure 9 in order to keep the description simple.

The lens barrel 3 is attached in the central part of the camera case 5 to hold the lens 2. The position of the lens 2 within the camera module is fixed by the lens barrel 3.

The IR (infrared ray) cut filter 4 is formed by depositing a thin film on a glass base material or formed by putting special metal into a glass base material and is disposed between the lens 2 and the image pickup device 6 on the lower side of an optical opening unit of the camera case 5. The IR cut filter 4 cuts out infrared rays in incident light (light from an object) to adjust the light to the human visible range before the light is incident on the image pickup device 6.

The camera case 5 has the optical opening unit with which the lens 2 and the IR cut filter 4 are provided and a housing (or a box-shaped member) that houses the image pickup device 6 and the electric parts 7. The camera case 5 assembles the lens 2, the IR cut filter 4, the image pickup device 6 and the DSP 9 together integrally and also covers all of these elements and protects the inside of the camera case 5.

Generally speaking, a CCD image sensor or a CMOS image sensor is used as the image pickup device 6. The image pickup device 6 is mounted on the substrate 8 and is electrically connected to electrode terminals (bonding pads) provided on the substrate 8 via wires.

As for the substrate 8, a print board is generally used which is obtained by disposing wirings for making electric connections among the image pickup device 6, the DSP 9, and the electric parts 7 required by the camera module, on a substrate such as a ceramic substrate or a glass epoxy substrate. In the present example, the image pickup device 6 is provided in the central part of the substrate 8, and various types of electric parts 7 such as a capacitor, a resistor, a power source noises cut filter for reducing power source noise and the like are provided around the image pickup device 6. In addition, an external connection terminal 11 is provided in the area from the lower part of the lateral surface of the substrate 8 to the lower surface, for making an electrical connection between an external device such as the main body of a mobile phone and the camera module 10.

The DSP 9 is a signal processing device that processes signals from the image pickup device 6. In the present example, the DSP 9 is disposed in a recessed part provided on the rear side of the substrate 8 in the central area thereof. It should be noted that in the case where the cameramodule 10 is incorporated in an electronic device such as a mobile phone, since the height of the camera module 10 is required to be small, it is acceptable to make the size of the substrate 8 larger so that the DSP 9 is disposed beside the image pickup device 6.

Position fixing pins 12 are provided integrally with the camera case 5 on the four corners of the substrate 8 and at predetermined positions between the image pickup device 6 and the electric parts 7 so as to fix the position of the substrate 8 with respect to the camera case 5. The camera case 5 and the substrate 8 are pasted with each other so as to be assembled together integrally.

In the case where the conventional cameral module 10 configured as described above is used in a mobile phone with a camera, when the camera module 10 receives electric signals from the mobile phone main body other than the camera part and electric signals from electric devices other than the mobile phone, some problems arise; for example, the image quality of a photographed image becomes low and/or the camera itself has a malfunction. Further, when electric signals from the camera module 10 (mainly from the image pickup device unit) goes to the outside, those electric signals may exert a bad influence on other electric devices causing noises and may also cause malfunctions of the electric devices.

As a countermeasure for these problems, the Patent Document 1, for example, presents a method for providing a shield against external noises by forming a shield layer made of an electrically conductive material on a camera case with the use of a plating method or a depositing method. In addition, another method is presented for shielding a camera module from external noises by manufacturing a camera case with an electrically conductive resin. Further, another method is suggested for electrically shielding the camera module more securely with improved conductivity by providing a metal layer with the use of a deposition processing or a plating processing on the surface of the electrically conductive resin.

[Patent Document 1] The Japanese Laid-Open Patent Publication No. 2003-324660

As described above, in the case where the conventional camera module 10 is used in an electronic information device such as a mobile phone with a camera, the following problems (1), (2), and (3) maybe experienced:
(1) Electric signals from the inside of the mobile phone and from the outside of the mobile phone penetrate the camera module 10 and are added to electric signals of the image pickup device 6 as noises, and consequently, the image quality of a photographed image becomes low. Particularly, in the case of a mobile phone, when signals from a high frequency (RF) unit penetrate the camera module 10, the image quality tends to become low easily. The reason for this is that the operational frequency of a mobile phone is high and also that the output power is large.
(2) Signals generated in the image pickup device 6 become noises and exert a bad influence on signals of the mobile phone main body other than the camera module 10.
(3) Signals generated in the image pickup device 6 become noises and cause other electric devices existing outside of the mobile phone to have malfunctions.

The problem (1) is caused when the camera module 10 receives noises from sections of the mobile phone main body other than the camera module 10 and noises from electric devices other than the mobile phone. The problems (2) and (3) are caused when the noises from the camera module 10 cause malfunctions in other electronic devices.

In order to prevent these problems, the Patent Document 1 presents shielding a camera module from electromagnetic radiation by making a camera case electrically conductive; however, according to this shielding method, only the camera case for the camera module is shielded, and the optical opening unit such as the lens unit is not shielded. Consequently, photographed images may receive a bad influence because of the noises entering and exiting through the lens unit.

In order to solve the problems of the conventional technique described above, the present invention aims to provide an image pickup device that obtains good photographed images by reducing electric noises inputted thereto and outputted therefrom as well as a camera module in which such an image pickup device is used.

### SUMMARY OF THE INVENTION

In order to achieve the aforementioned aim, the present invention provides an image pickup device including: a device body unit including a light receiving unit that converts incident light into electric signals; and a transmissive electrically conductive member provided at least on a light receiving unit side of a surface of the device body unit.

Further, it would be preferable to have an arrangement wherein the transmissive electrically conductive member in the image pick up device of the present invention is electrically connected to a reference potential unit.

Further, it would be preferable to have an arrangement wherein the image pickup device of the present invention further includes: front surface electrodes that are provided around the light receiving unit on the light receiving unit side of the surface of the device body unit; rear surface electrodes that are provided on a side opposite to the light receiving unit side of the surface of the device body unit; and wiring patterns that extend from the front surface electrodes to the rear surface electrodes respectively.

Further, it would be preferable to have an arrangement wherein the transmissive electrically conductive member in the image pickup device of the present invention is disposed so as to cover the light receiving unit side of the device body unit, and the transmissive electrically conductive member has one or more openings so as to avoid contact with a signal wiring portion and a power source witing portion, out of a ground wiring portion, the signal wiring portion, and the power source wiring portion of the reference potential unit that includes the front surface electrodes and the wiring patterns.

Further, it would be preferable to have an arrangement wherein the image pickup device of the present invention includes a transmissive electrically insulating member which is disposed so as to cover the light receiving unit side of the device body unit and has one or more openings so as to avoid contact with a ground wiring portion, out of the ground wiring portion, a signal wiring portion, and a power source wiring portion of the reference potential unit that includes the front surface electrodes and the wiring patterns, wherein the transmissive electrically conductive member is disposed so as to cover the transmissive electrically insulating member.

Further, it would be preferable to have an arrangement wherein the device body unit of the image pickup device of the present invention includes: a device substrate on which the light receiving unit is provided; and a substrate protecting member that protects a rear side of the device substrate.

Further, it would be preferable to have an arrangement wherein a transmissive protecting member that protects the device substrate is provided on a light receiving unit side of the device substrate in the image pickup device of the present invention.

Further, it would be preferable to have an arrangement wherein the transmissive electrically conductive member in the image pickup device of the present invention is provided at least on the light receiving unit side of the device body unit and on a side opposite to the light receiving unit side of the device body unit.

Further, it would be preferable to have an arrangement wherein the transmissive electrically conductive member in the image pickup device of the present invention is provided at least on the light receiving unit side of the device substrate and on a side opposite to the light receiving unit side of the device substrate.

Further, it is acceptable to have an arrangement wherein the transmissive electrically conductive member in the image pickup device of the present invention is a transparent electrically conductive paste resin attached to the light receiving unit side of the device body unit, or an epoxy resin provided on the light receiving unit side of the device body unit, or a transmissive electrically conductive film (or a transmissive electrically conductive layer) formed on the surface of the device body unit.

Further, it is acceptable to have an arrangement wherein the transmissive electrically conductive member in the image pickup device of the present invention is a transparent electrically insulating paste resin attached to the light receiving unit side of the device body unit, or an inorganic electrically insulating film (or an inorganic electrically insulating layer) such as an oxide film or a nitride film formed on the surface of the device body unit.

In order to achieve the aforementioned aim, the present invention presents an image pickup device including: a device substrate on which a light receiving unit that converts incident light into electric signals is provided; a transmissive protecting member that is adhered to a light receiving unit side of the device substrate via an adhesion unit and is disposed so as to cover the light receiving unit; and a transmissive electrically conductive layer covered by the transmissive protecting member.

Further, it is acceptable to have an arrangement wherein in the image pickup device of the present invention, the transmissive electrically conductive layer is disposed so as to face the light receiving unit, at least part of the adhesion unit is made of an electrically conductive member, and the transmissive electrically conductive layer is electrically connected to a reference potential unit provided on the device substrate via the electrically conductive member.

In order to achieve the aforementioned aim, the present invention provides a camera module in which the image pickup device according to any of Claims 1 to 11 is incorporated.

The following describes how the present invention works with the configuration described above.

According to the present invention, since the light receiving unit side of either the device body unit or the device substrate is covered by a transmissive electrically conductive member (hereafter simply referred to as a transmissive conductive member), the image pickup device itself is electrically shielded. Further, in order to stabilize a magnetic shield effect, the transmissive conductive member is electrically connected to a ground wiring portion that is made up of a ground electrode and/or its wiring pattern serving as a reference potential unit. By incorporating such an image pickup device into a camera module, it is possible to prevent electric signals inputted to the camera module from the outside such as a mobile phone from exerting a bad influence on the image pickup device by causing noises, as well as to prevent electric signals from a part of the mobile phone or the like other than the camera module from exerting a bad influence on the image pickup device by causing noises. Further, it is possible to prevent electric signals from the camera module from exerting a bad influence on the signals of the mobile phone main body and other electric devices existing outside of the mobile phone or the like.

In addition, by having an arrangement wherein the transmissive conductive member such as a transmissive electrically conductive layer (hereafter, simply referred to as a transmissive conductive layer) has an opening at least in a signal electrode portion thereof, it is possible to avoid a short circuit that may occur with a charging unit such as the signal wiring portion provided on the surface of the device body unit (the image pickup device substrate). Further, by having an arrangement wherein a transmissive electrically insulating member (hereafter, simply referred to as a transmissive insulating member), such as a transmissive electrically insulating layer (hereafter, simply referred to as a transmissive insulating layer), that has one or more openings in the ground wiring portion is provided, and a transmissive conductive member such as a transmissive conductive layer is further provided over the transmissive insulating member, it is possible to avoid a shortcircuit that may occur with other electrodes such as the ones in the signal wiring portion and the charging unit in the wiring pattern, as well as to electrically connect the transmissive conductive member such as a transmissive conductive layer to the ground wiring portion.

In addition, by having an arrangement wherein a transmissive protecting member is adhered to the light receiving unit side of the device substrate via an adhesion unit and is disposed so as to cover the light receiving unit, and further a transmissive conductive layer covers the transmissive protecting member, and wherein the transmissive conductive layer is disposed so as to face the light receiving unit, and at least part of the adhesion unit is electrically conductive, so that the transmissive conductive layer is electrically connected to the reference potential unit provided on the device substrate via the conductive part of the adhesion unit, it is possible to achieve a shielding affect easily.

As explained so far, according to the present invention, since the image pickup device itself is electrically shielded, it is possible to prevent electric signals inputted to the camera module from the outside of the mobile phone or the like from exerting a bad influence on the image pickup device by causing noises as well as to prevent electric signals from a part of the mobile phone or the like other than the camera module from exerting a bad influence on the image pickup device by causing noises.

Further, it is possible to prevent electric signals from the camera modules from exerting a bad influence on signals of the mobile phone main body or the like and other electric devices and other electronic information devices existing outside of the mobile phone or the like. Consequently, while there are demands that camera modules have a larger number of pixels and a higher image quality now and in the future, it is possible to realize a camera module having a high performance level that is not influenced by electric signal noises.

### BRIEF DESCRIPTION OF THE DRAWINGS

Figure 1A is an upper side view that shows an exemplary configuration of an image pickup device according to the first embodiment of the present invention.
Figure 1B is a side view from the left side of Figure 1A.
Figure 1C is a side view from the bottom side of Figure 1A.
Figure 1D is a rear side view of Figure 1A.
Figure 2A is an upper side view of the image pickup device according to the first embodiment of the present invention.
Figure 2B is a side view from the left side of Figure 2A.
Figure 2C is a side view from the bottom side of Figure 2A.
Figure 2D is a rear side view of Figure 2A.
Figure 2E is an upper side view that shows the pattern of the transparent conductive member.
Figure 3 is a cross sectional view of the main parts that shows an exemplary detailed configuration of an image pickup device according to the first embodiment of the present invention.
Figure 4A is a cross sectional view of the main parts that shows an exemplary configuration of a camera module according to the first and the second embodiments of the present invention.
Figure 4B is a rear side view of Figure 4A.
Figure 5A is an upper side view of the image pickup device according to the second embodiment of the present invention.
Figure 5B is a side view from the left side of Figure 5A.
Figure 5C is a side view from the bottom side of Figure 5A.
Figure 5D is a rear side view of Figure 5A.
Figure 5E is an upper side view that shows the pattern of the transparent conductive member.
Figure 5F is an upper side view that shows the pattern of the transparent insulating member.
Figure 6 is an enlarged view of Figure 5C.
Figure 7 is a cross sectional view of the main parts that shows an exemplary detailed configuration of an image pickup device according to the second embodiment of the present invention.
Figure 8A is an upper side view that shows an exemplary configuration of an image pickup device according to the fourth embodiment of the present invention.
Figure 8B is a cross sectional view at the line X-X' in Figure 8A.
Figure 9A is a cross sectional view of the main parts that shows an exemplary configuration of a conventional camera module.
Figure 9B is a rear side view of Figure 9A.

### DESCRIPTION OF THE PREFERRED EMBODIMENTS

The following describes first through fourth embodiments of an image pickup device and a camera module in which such an image pickup device is used according to the present invention, with reference to the drawings.

### First Embodiment

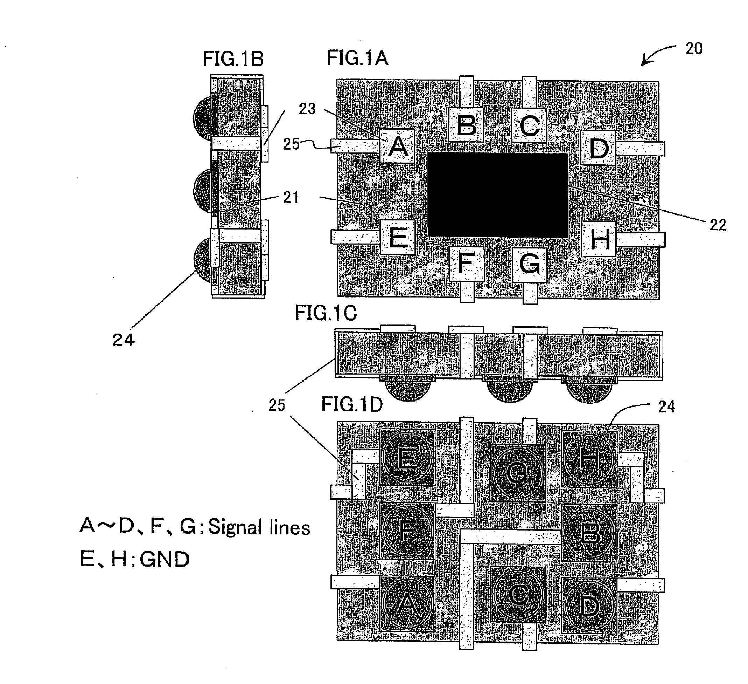

Figure 1A is an upper side view that shows an exemplary configuration of an image pickup device according to the first embodiment of the present invention. Figure 1B is a side view from the left side of Figure 1A. Figure 1C is a side view from the bottom side of Figure 1A. Figure 1D is a rear side view of Figure 1A.

As shown in FIGs. 1A to 1D, the image pickup device 20 is constituted with a CCD image sensor or a CMOS image sensor or the like that converts incident light from the outside (light from an object) into electric signals. A light receiving unit 22 for light from an object is provided in the central part of the surface of the image pickup device body unit (device body unit) 21. The light receiving unit 22 is included in an image pickup unit that forms an image of an object by converting incident light into electric signals (optical signals). Electrodes 23 (bonding pads) are provided around the light receiving unit 22. Bump electrodes 24 (solder bumps) are provided on the rear surface of the image pickup device body unit 21. Each of the electrodes 23 (A to H) is connected to a corresponding one of the bump electrodes 24 (A to H) via a corresponding one of the wiring patterns 25 provided so as to extend from the front surface via a lateral surface to the rear surface of the image pickup device body unit 21. In the present example, A to D, F, and G are in correspondence with signal wirings (signal electrodes and the wiring patterns connected thereto). E and H are in correspondence with ground wiring portion (ground electrodes and the wiring patterns connected thereto) serving as reference potential units.

For example, the Japanese National Phase PCT Laid-open Publication No. 2002-512436 discloses a configuration in which, as described above, the wiring patterns 25 are provided so as to extend from the front surface (upper surface) via a lateral surface to the rear surface (lower surface) of the image pickup device body unit 21, and the bump electrodes 24 (A to H) are provided on the rear surface. This publication includes a configuration in which a protecting layer made of glass or the like is provided on the front surface (upper surface) of the image pickup device body unit; however, the detailed structure of the image pickup device body unit 21 will be described later. Although there are various manufacturing methods for an image pickup device body unit , such as a chip array method, explanation of the methods will be omitted.

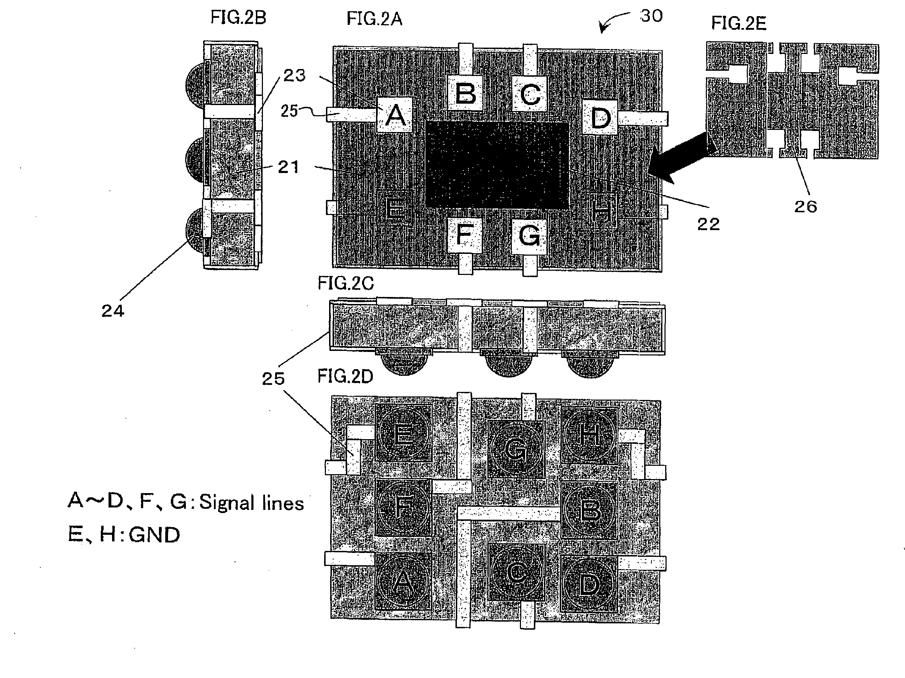

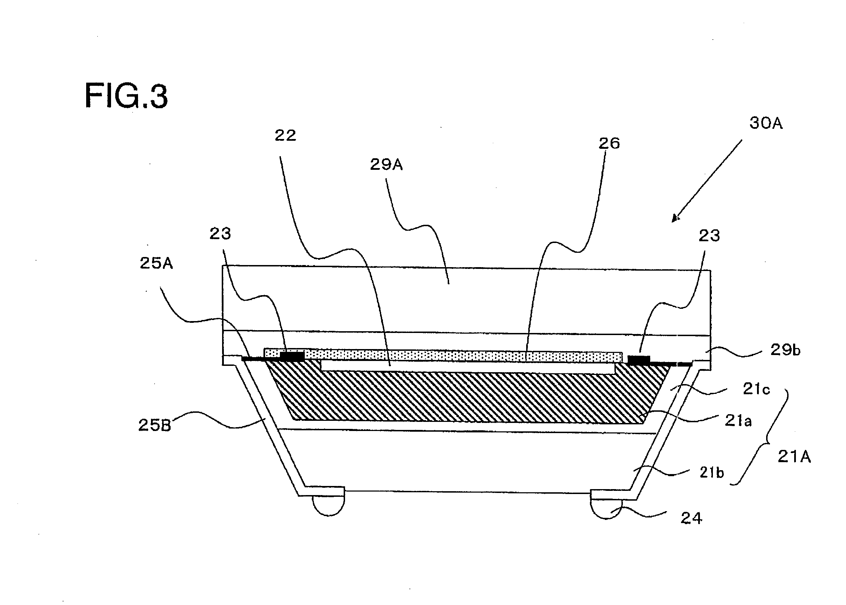

In the first embodiment, the transmissive conductive layer is disposed so as to cover the surface of the image pickup device body unit 21 shown in Figure 1, and the transmissive conductive layer is electrically connected to the ground electrodes. The following describes this configuration in further detail with reference to Figures 2A to 2E and Figure 3.

Figure 2A is an upper side view of the first embodiment of the image pickup device of the present invention. Figure 2B is a side view from the left side of Figure 2A. Figure 2C is a side view from the bottom side of Figure 2A. Figure 2D is a rear side view of Figure 2A. Figure 2E is an upper side view that shows the pattern of the transmissive conductive layer.

As shown in Figures 2A to 2E, as for the image pickup device 30, the surface of the image pickup device body unit (device body unit) 21 is covered by the transmissive conductive layer 26 serving as a transmissive conductive member. The transmissive conductive layer 26 has one or more openings in the parts that correspond to the conductive units of the signal wiring portion (the electrodes 23; A to D, F, and G) and the power source wiring portion and is electrically connected to the ground wiring portion (the electrodes 23; E, H, and the like).

Since being provided also over the light receiving unit 22, the transmissive conductive layer 26 is formed of a transmissive conductive material. For example, a transmissive conductive paste resin is applied or adhered by printing onto the surface of the image pickup device body unit 21 except for the signal wiring portion (the electrodes 23; A to D, F, G, and the conductive portions of the wiring pattern 25 that are connected thereto). This way, as shown in Figure 2E, it is possible to form the transmissive conductive layer 26 that has one or more openings in a part that corresponds to the signal wiring portion (the electrodes 23; A to D, F, and G and the conductive portions of the wiring patterns 25 that are connected thereto) and is electrically connected to the ground wiring portion (the ground electrodes E, H, and the like). The transmissive conductive layer 26 may be formed of an epoxy resin on the surface side of the image pickup device body unit 21, or may be formed as a transparent conductive film such as ITO, or may be formed as a metal thin film that has an extremely small thickness (for example by deposition).

The transmissive conductive layer 26 formed as described above is substantially transparent; therefore, there is no problem even if the transmissive conductive layer 26 is formed over the light receiving unit 22.

Further, since the transmissive conductive layer 26 is electrically connected to the ground wiring portion (the electrodes 23; E and H, and the conductive portions of the wiring patterns 25 that are connected thereto) of the image pickup device 30, it is possible to arrange the transmissive conductive layer 26 tobe at a ground potential (GND) via the ground wiring. It is therefore possible to electrically shield the image pickup device 30 by covering the surface of the body thereof.

Further, the transmissive conductive layer 26 is formed except for the signal wiring portion (the electrodes 23; A to D, F, and G, and the conductive portions of the wiring pattern 25 that are connected thereto) (so as to have predetermined intervals); therefore, the transmissive conductive layer 26 does not have a shortcircuit with the signal wiring portion (the electrodes 23; A to D, F, and G, and the conductive portions of the wiring pattern 25 that are connected thereto) and the power source wiring portion (the power source electrode and the conductive portions of the wiring patterns that are connected thereto).

The following describes an exemplary detailed configuration in which the image pickup device 30 of the first embodiment is realized as an image pickup device 30A using a technique disclosed in the aforementioned Japanese National Phase PCT Laid-open Publication No. 2002-512436. It should be noted that the outline of the image pickup device 30 of the first embodiment is in a rectangular shape in a cross section; however, the image pickup device 30A is different from the image pickup device 30 in that it has an outline in the shape of an inverted trapezoid in a cross section. The difference is owing to the fact that the structure shown in Figures 1 and 2 is very conceptual. In actuality, the structure shown in Figure 3 is easy to manufacture. It should be noted, however, that the present invention is not limited to the shapes illustrated in the drawings.

As shown in Figure 3, the image pickup device body unit 21A, which is an exemplary detailed configuration of the image pickup device body unit 21, includes an image pickup device substrate 21a that includes a light receiving unit 22 in the central part thereof, an insulating protecting member 21b serving as a substrate protecting member, and an adhesion member 21c that adheres these to each other.

The image pickup device substrate 21a is configured in such a manner that a plurality of device structures manufactured on a silicon wafer are divided in segments and separated from one another. A light receiving unit 22 for light from an object is provided on the image pickup device substrate 21a. The light receiving unit 22 is included in an image pickup unit that forms an image of an object by converting incident light into electric signals (optical signals). The wiring pattern 25A is formed so as to extend from the light receiving unit 22 side of the surface of the image pickup device substrate 21a to the vicinity of the lateral surface of the image pickup body unit 21A. The wiring pattern 25B to which the wiring pattern 25A is electrically connected is formed so as to extend from the lateral surface of the image pickup device body unit 21A to the bump electrodes 24 provided on the rear surface of the image pickup device body unit 21A. Each of some of the electrodes 23 provided on the surface on the left side of Figure 3 of the light receiving unit 22 in the image pickup device substrate 21a corresponds to the ground electrode E or H out of the electrodes 23 shown in Figures 1 and 2. Each of some of the electrodes 23 provided on the surface on the right side of Figure 3 of the light receiving unit 22 in the image pickup device substrate 21a corresponds to the signal electrode A, B, C, D, F, G or the like, out of the electrodes 23 shown in Figures 1 and 2.

On the front surface side of the image pickup device body unit 21A (on the front surface side of the image pickup device substrate 21a), a transmissive conductive layer 26 is formed so as to be electrically insulating from the light receiving unit 22.

Further, on the front surface side of the light receiving unit 22 in the image pickup device body unit 21A, a transmissive protecting member 29a which is electrically insulating is provided, which may be made of a glass material. An epoxy resin material may be used fox an adhesion member 29b that adheres the transmissive protecting member 29a to the surface of the transmissive conductive layer 26 and other parts of the surface of the image pickup device body unit 21A. The insulating protecting member 21b does not have to be transmissive but may be made of a glass material. An epoxy resin material may be used also for an adhesion member 21c that adheres the insulating protecting member 21b to the rear surface of the image pickup device substrate 21a. These adhesion member 21c and 29b serve as adhesive layers.

It should be noted that although the insulating transmissive protecting member 29a made of a glass material is provided on the front surface side of the light receiving unit 22 (on the front surface side of the image pickup device substrate 21a) in the image pickup device body unit 21A, the present invention is not limited to this arrangement. It is acceptable to use a transmissive protecting film.

Furthermore, at least an insulating protecting film is formed on the surface of the light receiving unit 22 in the image pickup device body unit 21A and further the transmissive conductive layer 26 is formed over it. Thus, the light receiving unit 22 is electrically insulating from the transmissive conductive layer 26.

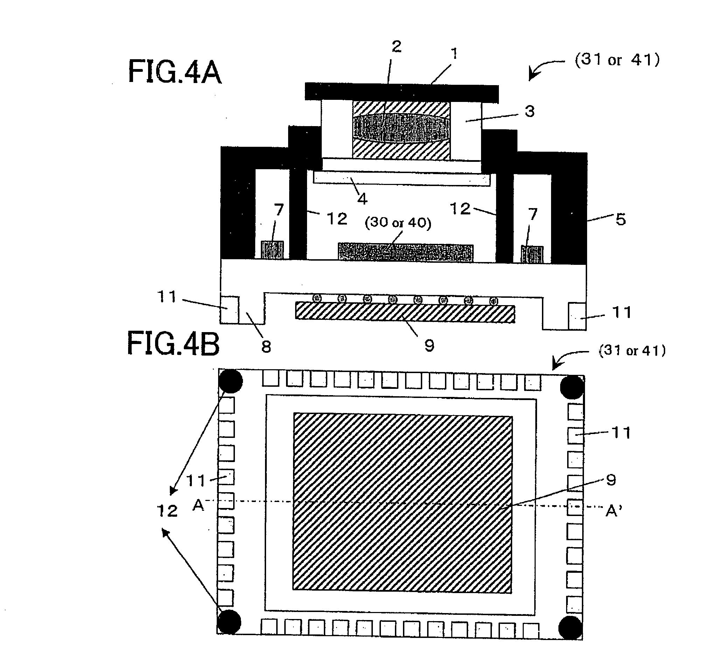

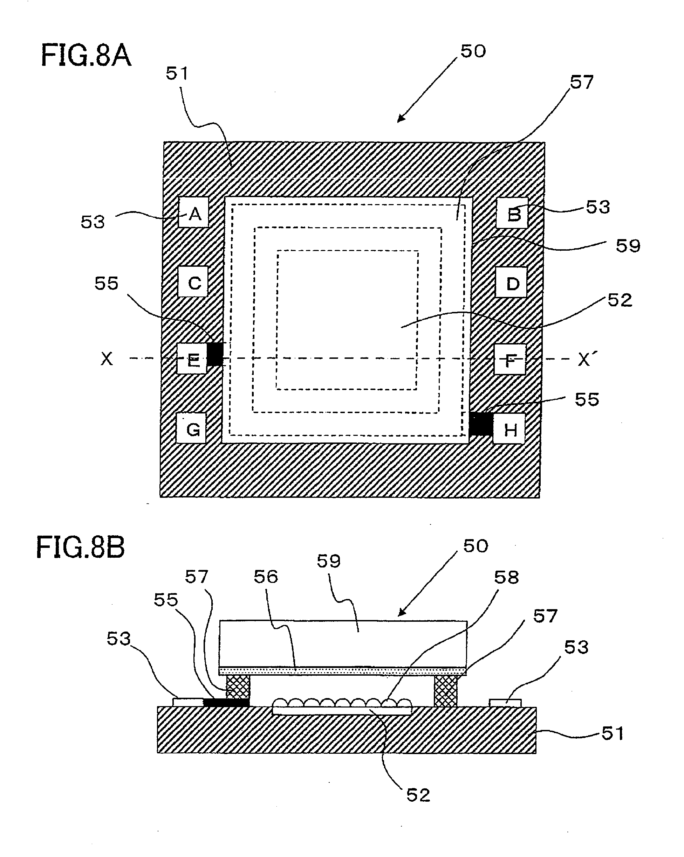

Figure 4A is a cross sectional view of the main parts to show an exemplary configuration of a camera module according to the first embodiment. Figure 4B is a rear side view of the camera module shown in Figure 4A. Figure 4A is a cross sectional view at the line A-A' in Figure 4B. In Figures 4A and 4B, the same reference numbers are given to some of the constituent elements that have the same functional effects as the constituent elements of the conventional camera module shown in Figure 8, and explanation thereof will be omitted.

It should be noted that the image pickup device 6 is electrically connected to the substrate 8 with wires according to the conventional technique; however, according to the first embodiment, the image pickup device 30 (or 30A) is connected to the substrate 8 using the bump electrodes 24; therefore, the wire connections are unnecessary. In addition, although Figure 4 shows the IR cut filter 4, alternatively, it is acceptable to provide the transmissive protecting member 29a with an infrared ray cut function so that the IR cut filter 4 can be omitted.

By having an arrangement wherein the image pickup device 30 (or 30A) according to the first embodiment is incorporated into the camera module 31 shown in Figures 4A and 4B, since the image pickup device 30 (or 30A) is electrically shielded, the main parts of the camera module 31 are shielded from electromagnetic radiation. Consequently, it is possible to prevent electric signals inputted to the camera module 31 from the outside such as a mobile phone from exerting a bad influence on the image pickup device 30 (or 30A) by causing noises, as well as to prevent electric signals from a part of the mobile phone other than the camera module 31 from exerting a bad influence on the image pickup device 30 (or 30A) by causing noises. Furthermore, it is possible to prevent electric signals from the camera module 31 from exerting a bad influence on the signals of the mobile phone main body and other electric devices existing outside of the mobile phone.

### Second Embodiment

In the first embodiment, the transmissive conductive layer 26 has one or more openings in the parts that correspond to the conductive units of the signal wiring portion (the electrodes 23; A to D, F, and G, and the wiring patterns 25 that are connected thereto) and the power source wiring portion, out of the electrodes 23 (the bonding pads) and the wiring patterns 25 that are provided on the front surface side of the image pickup device body unit 21 (or 21A). In the second embodiment, however, the surface of the image pickup device body unit 21 is covered by a transmissive insulating 27 to be described later that has one or more openings in the parts that correspond to the conductive unit of the ground wiring portion (the electrodes 23; E and H and the wiring patterns 25 that are connected thereto) and further, a transmissive conductive layer 26A to be described later is provided over the transmissive insulating layer 27.

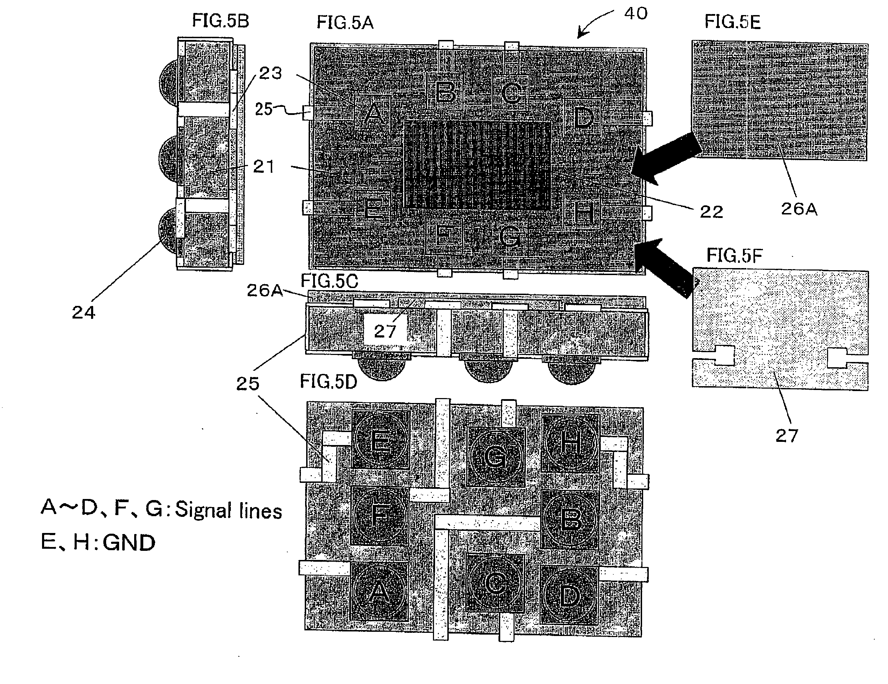

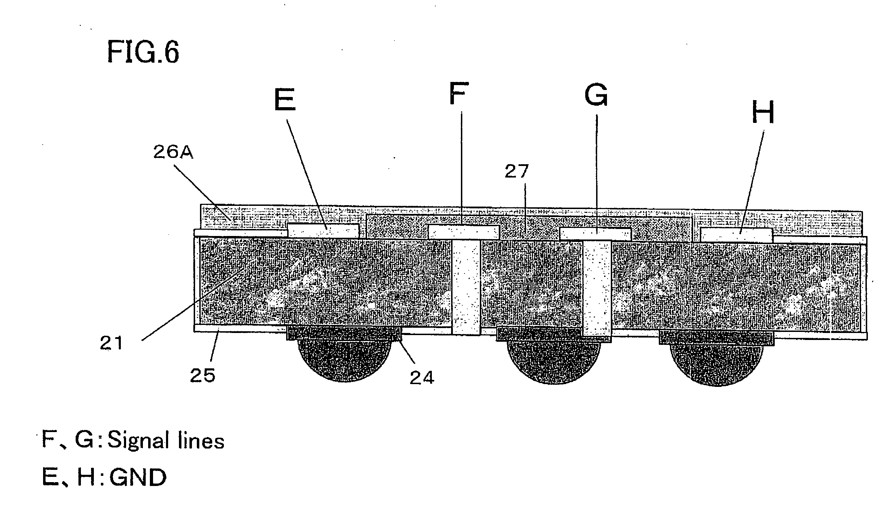

Figure 5A is an upper side view of the second embodiment of the image pickup device of the present invention. Figure 5B is a side view from the left side of Figure 5A. Figure 5C is a side view from the bottom side of Figure 5A. Figure 5D is a rear side view of Figure 5A. Figure 5E is an upper side view that shows the pattern of the transmissive conductive layer. Figure 5F is an upper side view that shows the pattern of the transmissive insulating layer. Figure 6 is an enlarged view of Figure 5C.

As shown in Figures 5A to 5F and Figure 6, as for the image pickup device 40, a transmissive insulating layer 27 is provided on the surface of the image pickup device body unit 21, and further a transmissive conductive layer 26A is provided over the transmissive insulating layer 27.

The transmissive insulating layer 27 has one or more openings in a ground wiring portion (the electrodes 23; E and H and the wiring patterns 25 that are connected thereto). The transmissive conductive layer 26A is provided so as to cover the whole surface of the image pickup device body unit 21 including over the ground wiring portion and is electrically connected to the ground wiring portion (the electrodes 23; E and H and the wiring patterns 25 that are connected thereto) via the one or more openings.

Further, the transmissive insulating layer 27 is formed also over the light receiving unit 22 provided at the central part of the surface of the image pickup device body unit 21. Thus, the transmissive insulating layer 27 is formed of a transmissive insulating material. For example, in order to form the transmissive insulating layer 27 that has one or more openings for the conductive unit of the ground wiring portion (the electrodes 23; E and H, and the wiring patterns 25 that are connected thereto), as shown in Figure 5F, a transmissive insulating paste resin is applied or adhered by printing onto the surface of the image pickup device body unit 21 except for the conductive unit of the ground wiring portion (the electrodes 23; E and H, and the wiring patterns 25 that are connected thereto).

The transmissive insulating layer 27 may be formed of an epoxy resin on the surface side of the image pickup device body unit 21. The transmissive insulating layer 27 may be formed as an inorganic insulating film such as a silicon oxide film or a nitride silicon film.

Subsequently, in order to form the transmissive conductive layer 26A that covers the whole surface of the image pickup device body unit 21, as shown in Figure 5E and is electrically connected to the conductive unit of the ground wiring portion (the electrodes 23; E and H, and the wiring patterns 25 connected thereto) over the transmissive insulating layer 27, for example, a transmissive conductive paste resin is applied or adhered by printing onto the surface of the image pickup device body unit 21.

The transmissive conductive layer 26Amay be formed of an epoxy resin on the front surface side of the image pickup device body unit 21, or may be formed as a transmissive conductive film such as ITO, or may be formed as a metal thin film that has an extremely small thickness.

Further, since the transmissive insulating layer 27 is provided over the conductive units of the signal wiring portion (the electrodes 23; A to D, F, and G, and the wiring patterns 25 that are connected thereto) and the power source wiring portion, the transmissive conductive layer 26A is electrically out of contact with the signal wiring portion and the power source wiring portion, and therefore does not have a shortcircuit with the signal wiring portion and the power source wiring portion. Further, since the transmissive conductive layer 26A is electrically connected to the conductive unit of the ground wiring portion (the electrodes 23; E and H, and the wiring patterns 25 that are connected thereto) of the image pickup body unit 21, it is possible to arrange the transmissive conductive layer 26A to be at a ground potential (GND) via the ground wiring. It is therefore possible to cover over the image pickup device 40 so as to electrically provide a magnetic shield for the inside thereof.

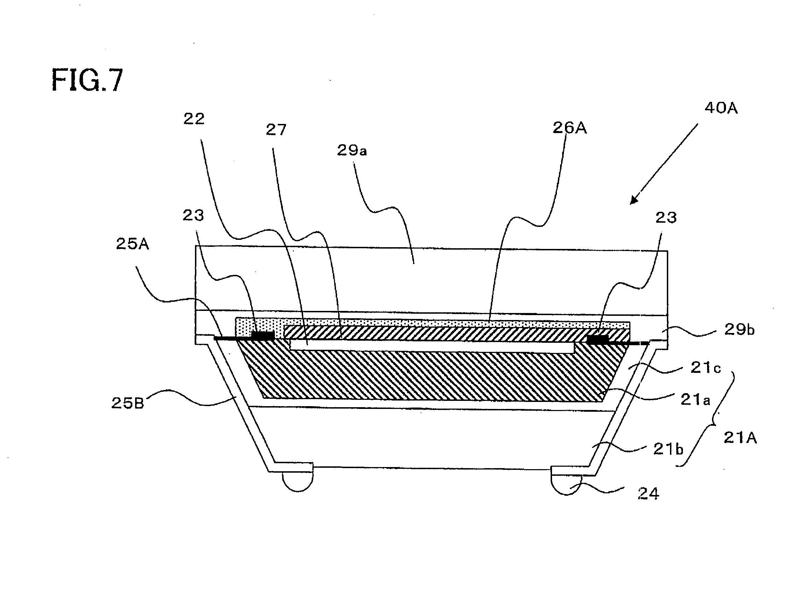

The following describes an exemplary detailed configuration in which the image pickup device 40 of the second embodiment is realized as an image pickup device 40A using a technique disclosed in the aforementioned Japanese National Phase PCT Laid-open Publication No. 2002-512436. It should be noted that the outline of the image pickup device 40 of the second embodiment is in a rectangular shape in a cross section; however, the image pickup device 40A is different from the image pickup device 40 in that it has an outline in the shape of an inverted trapezoid in a cross section. The difference is owing to the fact that the structure shown in Figures 5 and 6 is very conceptual. In actuality, the structure shown in Figure 7 is easy to manufacture. It should be noted, however, that the present invention is not limited to the shapes illustrated in the drawings.

As shown in Figure 7, the image pickup device body unit 21A, which is an exemplary detailed configuration of the image pickup device body unit 21, includes an image pickup device substrate 21a that includes a light receiving unit 22 in the central part thereof, an insulating protecting member 21b serving as a substrate protecting member, and an adhesion member 21c that adheres these to each other.

The image pickup device substrate 21a is configured in such a manner that a plurality of device structures manufactured on a silicon wafer are divided in segments and separated from one another. A light receiving unit 22 for light from an object is provided on the image pickup device substrate 21a. The light receiving unit 22 is included in an image pickup unit that forms an image of an object by converting incident light into electric signals (optical signals). The wiring pattern 25A is formed so as to extend from the light receiving unit 22 side of the surface of the image pickup device substrate 21a to the vicinity of the lateral surface of the image pickup body unit 21A. The wiring pattern 25B to which the wiring pattern 25A is electrically connected is formed so as to extend from the lateral surface of the image pickup device body unit 21A to the bump electrodes 24 provided on the rear surface of the image pickup device body unit 21A. Each of some of the electrodes 23 provided on the surface on the left side of Figure 7 of the light receiving unit 22 in the image pickup device substrate 21a corresponds to the ground electrode E or H out of the electrodes 23 shown in Figures 5 and 6. Each of some of the electrodes 23 provided on the surface on the right side of Figure 7 of the light receiving unit 22 in the image pickup device substrate 21a corresponds to the signal electrode A, B, C, D, F, G or the like, out of the electrodes 23 shown in Figures 5 and 6.

On the front surface side of the image pickup device body unit 21A (on the front surface side of the image pickup device substrate 21a), a transmissive insulating layer 27 and further, a transmissive conductive layer 26A are sequentially formed.

Furthermore, on the front surface side of the light receiving unit 22 in the image pickup device body unit 21A, a transmissive protecting member 29a which is electrically insulating is provided, which may be made of a glass material. An epoxy resin material may be used for an adhesion member 29b that adheres the transmissive protecting member 29a to the surface of the transmissive conductive layer 26A and other parts of the surface of the image pickup device body unit 21A. The insulating protecting member 21b does not have to be transmissive but may be made of a glass material. An epoxy resin material may be used also for an adhesion member 21c that adheres the insulating protecting member 21b to the rear surface of the image pickup device substrate 21a. These adhesion member 21c and 29b serve as adhesive layers.

It should be noted that although the insulating transmissive protecting member 29a made of a glass material is provided on the front surface side of the light receiving unit 22 (on the front surface side of the image pickup device substrate 21a) in the image pickup device body unit 21A, the present invention is not limited to this arrangement. It is acceptable to use a transmissive protecting film.

Further, at least an insulating protecting film is formed on the surface of the light receiving unit 22 in the image pickup device body unit 21A. The transmissive insulating layer 27 is further formed over the insulating protecting film, and furthermore, the transmissive conductive layer 26A is formed over the transmissive insulating layer 27.

Figure 4A is a cross sectional view of the main parts to show an exemplary configuration of a camera module according to the second embodiment. Figure 4B is a rear side view of the camera module shown in Figure 4A. Figure 4A is a cross sectional view at the line A-A' in Figure 4B. In Figures 4A and 4B, the same reference numbers are given to some of the constituent elements that have the same functional effects as the constituent elements of the conventional camera module shown in Figure 6, and explanation thereof will be omitted.

It should be noted that the image pickup device 6 is electrically connected to the substrate 8 with wires according to the conventional technique; however, according to the second embodiment, the image pickup device 40 (or 40A) is connected to the substrate 8 using the bump electrodes 24; therefore, the wire connections are unnecessary. In addition, although Figure 3 shows the IR cut filter 4, alternatively, it is acceptable to provide the transmissive protecting member 29a with an infrared ray cut function so that the IR cut filter 4 can be omitted.

By having an arrangement wherein the image pickup device 40 (or 40A) according to the second embodiment is incorporated into the camera module 41 shown in Figures 4A and 4B, since the image pickup device 40 (or 40A) is electrically shielded, the main parts of the camera module 41 are shielded from electromagnetic radiation. Consequently, it is possible to prevent electric signals inputted to the camera module 41 from the outside such as a mobile phone from exerting a bad influence on the image pickup device 40 (or 40A) by causing noises, as well as to prevent electric signals from a part of the mobile phone other than the camera module 41 from exerting a bad influence on the image pickup device 40 (or 40A) by causing noises. Further, it is possible to prevent electric signals from the camera module 41 from exerting a bad influence on the signals of the mobile phone main body and other electric devices existing outside of the mobile phone.

### Third Embodiment

In the first and second embodiments, the front surface side of the image pickup device body unit 21 (or 21A) is covered by the transmissive conductive layer 26 or 26A so that the inside thereof is magnetically shielded. In the third embodiment, like in the case with the transmissive conductive layer 26 or 26A, the rear surface side (which may also include the lateral surface) is also additionally covered by a transmissive conductive layer.

In the case of the rear surface of the image pickup device body unit 21, like in the case of the front surface on which the transmissive conductive layer 26 is provided, the transmissive conductive layer has one or more openings in the parts that correspond to the conductive units of the signal wiring portion (the bump electrodes 24; A to D, F, and G, and the wiring patterns 25 that are connected thereto) and the power source wiring portion, out of the bump electrodes 24 (solder bumps) provided on the rear side of the image pickup device body unit 21 and the wiring patterns 25 that are connected thereto. Alternatively, like in the case of the front surface on which the transmissive conductive layer 26A is provided, it is acceptable to have an arrangement wherein the rear surface of the image pickup device body unit 21 is covered by a transmissive insulating layer that has one or more openings in the parts that correspond to the conductive units of the ground wiring portion (the bump electrodes 24; E and H, and the wiring patterns 25 that are connected thereto), and further a transmissive conductive layer is disposed over the whole surface of the transmissive insulating layer. Alternatively, it is also acceptable to dispose a transmissive conductive layer also on the rear surface of the image pickup device substrate 21a.

Thus, according to the third embodiment, the surface (which includes the front surface side and the rear surface side, and may also include the lateral surface side) of the image pickup device is covered by either the transmissive conductive layer 26 or 26A, and the transmissive conductive layer is electrically connected to a ground electrode. By having this arrangement, it is possible to shield the main parts of the camera module in the manner of electromagnetic waves more securely than the cases of the first and the second embodiments and to prevent electric noises from the outside of the camera module from exerting an influence on the image pickup device and to prevent electric signals from the image pickup device in the camera module from exerting an influence on other electric devices. It should be noted that the expression "surface" used here may denote only "the front surface side" as opposed to "the rear surface side", or may denote both "the front surface side" and "the rear surface side". In short, the expression "surface" denotes the surface of the image pickup device which includes the front surface side and the rear surface side, and which may include the lateral surface side.

As explained above, according to the first through third embodiments, since the surface of the image pickup device body unit 21 (or 21A) is covered by the transmissive conductive layer 26 or 26A that is made of a transmissive conductive paste resin and that is electrically connected to a ground electrode, it is possible to electrically shield the image pickup device 30 (or 30A) or 40 (or 40A) itself. Consequently, it is possible to shield the main parts of the camera module 31 or 41 from electromagnetic radiation. By having this arrangement, it is possible to shield the camera module 31 or 41 and to prevent electromagnetic wave noises from the outside of the camera module 31 or 41 from exerting an influence on the image pickup device 30 (or 30A) or 40 (or 40A) and to prevent electric signals from the image pickup device 30 (or 30A) or 40 (or 40A) in the camera module 31 or 41 from exerting an influence on other electric devices.

### Fourth Embodiment

Figure 8A is an upper side view that shows an exemplary configuration of an image pickup device according to the fourth embodiment of the present invention. Figure 8B is a cross sectional view at the line X-X' in Figure 8A.

As shown in Figures 8A and 8B, the image pickup device 50 is constituted with a CCD image sensor or a CMOS image sensor or the like that converts incident light from the outside (light from an object) into electric signals. A light receiving unit 52 for light from an object is provided in the central part of the surface of the device substrate 51. The light receiving unit 52 is included in an image pickup unit that forms an image of an object by converting incident light into electric signals (optical signals). Electrodes 53 (bonding pads) are provided around the light receiving unit 52 on the surface of the device substrate 51. In the present example, A to D, F, and G correspond to signal electrodes. E and H correspond to ground electrodes serving as reference potential units. A micro lens 58 is disposed over the light receiving unit 52 in order to converge incident light (light from an object) onto photoelectric conversion units.

According to the fourth embodiment, as shown in Figure 8, on the light receiving unit 52 side of the device substrate 51, a transmissive protecting member 59 is held and adhered by an adhesion unit 57 so as to form a space covering the light receiving unit 52. A transmissive conductive layer 56 is provided on the lower side of the transmissive protecting member 59 that faces the light receiving unit 52. Further, the adhesion unit 57 is made of a conductive adhesive. The transmissive conductive layer 56 is electrically connected to the ground electrodes E and H out of the electrodes 53 (A to H) via the conductive adhesion unit 57 and the wiring unit 55 formed with a pattern on the device substrate 51. Accordingly, since the transmissive conductive layer 56 is electrically connected to E and H of the ground electrodes 53, it is possible to arrange the transmissive conductive layer 56 to be at a ground potential (GND) via the ground wiring. Thus, it is possible to shield the image pickup device 50 electromagnetically.

It should be noted that the present example shows a configuration in which the whole adhesion unit 57 is made of a conductive adhesive; however, it is acceptable if at least part of the adhesion unit 57 that is in contact with the wiring unit 55 is electrically conductive. Thus, it is acceptable to have an arrangement wherein, for example, the adhesion unit 57 for adhering and fixing the transmissive protecting member 59 to the device substrate 51 is a non-conductive member, while another conductive adhesion unit is provided so as to be in contact with the transmissive conductive layer 56 and the wiring unit 55. Further, it is acceptable to have an arrangement wherein the transmissive conductive layer 56 is disposed on the surface (upper surface) on the outside of the transmissive protecting member 59 (the opposite side that faces away from the light receiving unit 52), or wherein the adhesion unit 57 is not used as a joint member but another joint member is provided; however, the manufacturing is easier when the transmissive conductive layer 56 is disposed so as to face the light receiving unit 52 and when at least part of the adhesion unit 57 adhering the device substrate 51 to the transmissive protecting member 59 is electrically conductive so that this conductive part is used in the electrical connection.

The following briefly describes the manufacturing method of the image pickup device 50 according to the fourth embodiment. Firstly, a device including the light receiving unit 52 is formed in a silicon wafer. On the other hand, the transmissive conductive layer 56 is formed on one of the main surfaces of a glass sheet material by applying an epoxy resin, forming a transparent conductive film such as ITO by deposition, and forming a metal thin film having an extremely small thickness by deposition, or the like. Subsequently, a conductive adhesive is provided in a pattern on the facing surface of a Si wafer or a glass material. For this pattern forming, for example, after an adhesive obtained by mixing a photosensitive adhesive (e.g. a UV curable resin being an acrylic resin) with a thermosetting resin (e.g. an epoxy resin) is evenly applied, pattern forming (called patterning) is performed with the use of a publicly-known photolithography technique. This way, it is possible to form a large number of adhesion units 57 simultaneously. By forming a large number of adhesion units 57 simultaneously, it is possible to improve productivity. The reason why a photosensitive adhesive is mixed with a thermosetting resin is because when the adhesive has photosensitivity, the patterning of the adhesion unit 57 is easily and precisely performed using processing of the photolithography technique such as exposure and development. Since the patterning of the adhesion unit 57 is performed with a high level of precision, even if the area other than the light receiving unit 52 is small, it is possible to form the adhesion unit 57 with a high level of precision. It should be noted that for the pattern forming of the adhesion unit 57, it is acceptable to use other forming methods such as a printing method including silk screen printing, drawing with the use of a dispenser, forming patterns with ink jet, and the like.

Further, by dividing the silicon wafer and the glass sheet material into segments that are separate from one another, individual image pickup devices 50 as shown in Figure 8 are manufactured. It should be noted that the description provided here explains that the glass sheet material in the form of a single sheet is adhered onto the silicon wafer before being divided into segments; however, it is acceptable to have an arrangement wherein a glass sheet material is divided into individual segments before being adhered to a silicon wafer, and the silicon wafer is divided into segments.

Further, the following describes a camera module as a product in which the image pickup device 50 according to the fourth embodiment is used. Since the exemplary configuration of the cameramodule in which the image pickup device 50 of the fourth embodiment is used is substantially the same as the one shown in Figure 9 (the conventional technique), illustration by way of drawings will be omitted. The camera module according to the fourth embodiment is obtained by replacing the image pickup device 6 in Figure 9 with the image pickup device 50 according to the fourth embodiment described above. It should be noted that although IR cut filter 4 is shown in Figure 9, it is acceptable to provide the transmissive protecting member 59 with an infrared ray cut function so that the IR cut filter 4 can be omitted.

By having an arrangement wherein the image pickup device 50 according to the fourth embodiment is incorporated into a camera module, since the image pickup device 50 is electromagnetically shielded, the main parts of the camera module are shielded from electromagnetic radiation. Consequently, it is possible to prevent electric signals inputted to the camera module from the outside such as amobile phone from exerting a bad influence on the image pickup device 50 by causing noises, as well as to prevent electric signals from a part of the mobile phone other than the camera module from exerting a bad influence on the image pickup device 50 by causing noises. Furthermore, it is possible to prevent electric signals from the camera module from exerting a bad influence on the signals of the mobile phone main body and other electric devices existing outside of the mobile phone.

Although in the first to fourth embodiments, an arrangement is made wherein the transmissive conductive layer 26, 26A, or 56 serving as a transmissive conductive member is electrically connected to the ground wiring portion serving as a reference potential unit; however, the present invention is not limited to this arrangement. Even if the transmissive conductive layer 26 and 26A is not electrically connected to the ground wiring portion, it is possible to have some electromagnetic shielding effects.

Although no particular description is provided in the first through fourth embodiments, a member that is not thick enough to be referred to as a layer may be used as a transmissive conductive member, in addition to, or instead of, the transmissive conductive layer 26, 26A, or 56.

Furthermore, although no particular description is provided in the first through fourth embodiments, a reference potential part that is not grounded and free may be included in the reference potential unit, in addition to, or instead of, the ground wiring portion.

Furthermore, the image pickup devices according to the first and second embodiments are not limited to the detailed configuration of the image pickup devices shown in Figures 3 and 7.

As explained so far, although the present invention has been illustrated using the preferred embodiments of the present invention, namely the first through fourth embodiments , the present invention should not be construed within the limitation of the first through fourth embodiments. It is understood that the scope of the present invention should be construed only by the scope claimed in the claims. It is understood that an ordinary person skilled in the art is able to embody an equivalent scope based on the description of the present invention and technical common sense according to the specific preferred embodiments of the present invention, namely the first through third embodiments. It is understood that the contents of the patents, patent applications, and other documents cited in the present specification should be used as reference supports for the present specification as if all such publications were incorporated herein.

The present invention aims to, in the field of image pickup devices such as CMOS image sensors and CCD image sensors used in image pickup units of video cameras, digital still cameras, mobile phones with a camera, portable information terminal devices with a camera and the like, as well as camera modules including such image pickup devices, to shield the main parts of the camera module from electromagnetic radiation by shielding the image pickup device itself from electromagnetic radiation and to prevent electric signals from the outside of the mobile phone or the like and from a part of the mobile phone or the like other than the camera module from exerting a bad influence on photographed images by causing noises and to prevent electric signals from the camera module from exerting a bad influence on electric devices that are on the outside of the mobile phone or the like and in the parts of the mobile phone other than the camera module. Consequently, it is possible to realize a camera module with a high performance level.. The present invention may be used in the image pickup units of various types of electronic devices such as video cameras, digital still cameras, mobile phones with a camera, and mobile information terminal devices with a camera in order to make it possible to obtain good photographed images as well as to realize electronic devices with a high performance level without exerting a bad influence on the properties of those electronic devices.

## Claims

1. An image pickup device comprising:
a device body unit including a light receiving unit that converts incident light into electric signals; and
a transmissive electrically conductive member provided at least on a light receiving unit side of a surface of the device body unit.

2. An image pickup device according to claim 1, wherein
the transmissive electrically conductive member is electrically connected to a reference potential unit.

3. An image pickup device according to claim 1, further comprising:
front surface electrodes that are provided around the light receiving unit on the light receiving unit side of the surface of the device body unit;
rear surface electrodes that are provided on a side opposite to the light receiving unit side of the surface of the device body unit; and
wiring patterns that extend from the front surface electrodes to the rear surface electrodes respectively.

4. An image pickup device according to claim 1, wherein
the transmissive electrically conductive member is disposed so as to cover the light receiving unit side of the device body unit, and
the transmissive electrically conductive member has one or more openings so as to avoid contact with a signal wiring portion and a power source wiring portion, out of a ground wiring portion, the signal wiring portion, and the power source wiring portion of the reference potential unit that includes the front surface electrodes and the wiring patterns.

5. An image pickup device according to claim 1, comprising:
a transmissive electrically insulating member which is disposed so as to cover the light receiving unit side of the device body unit and has one or more openings so as to avoid contact with a ground wiring portion, out of the ground wiring portion, a signal wiring portion, and a power source wiring portion of the reference potential unit that includes the front surface electrodes and the wiring patterns, wherein
the transmissive electrically conductive member is disposed so as to cover the transmissive electrically insulating member.

6. An image pickup device according to claim 1, wherein
the device body unit includes:
a device substrate on which the light receiving unit is provided; and
a substrate protecting member that protects a rear side of the device substrate.

7. An image pickup device according to claim 6, wherein
a transmissive protecting member that protects the device substrate is provided on a light receiving unit side of the device substrate.

8. An image pickup device according to claim 1, wherein
the transmissive electrically conductive member is provided at least on the light receiving unit side of the device body unit and on a side opposite to the light receiving unit side of the device body unit.

9. An image pickup device according to claim 6, wherein
the transmissive electrically conductive member is provided at least on the light receiving unit side of the device substrate and on a side opposite to the light receiving unit side of the device substrate.

10. An image pickup device comprising:
a device substrate on which a light receiving unit that converts incident light into electric signals is provided;
a transmissive protecting member that is adhered to a light receiving unit side of the device substrate via an adhesion unit and is disposed so as to cover the light receiving unit; and
a transmissive electrically conductive layer covered by the transmissive protecting member.

11. An image pickup device according to claim 10, wherein
the transmissive electrically conductive layer is disposed so as to face the light receiving unit,
at least part of the adhesion unit is made of an electrically conductive member, and
the transmissive electrically conductive layer is electrically connected to a reference potential unit provided on the device substrate via the electrically conductive member.

12. A camera module comprising an image pickup device according to claim 1.
